# EUROPÄISCHE PATENTSCHRIFT

(11) **EP 2 656 408 B1**
(45) Veröffentlichungstag und Bekanntmachung des Hinweises auf die Patenterteilung: **21.10.2015**
(21) Anmeldenummer: 11801739.1
(22) Anmeldetag: 20.12.2011
(51) Int. Cl.: H01L 41/047, H02N 2/06

(54) **AKTORSYSTEM UND ANSTEUERUNG EINES AKTORS**
ACTUATOR SYSTEM, AND CONTROL OF AN ACTUATOR
SYSTÈME D'ACTIONNEUR ET COMMANDE D'ACTIONNEUR

(30) Priorität: 22.12.2010 DE 102010055621
(43) Veröffentlichungstag der Anmeldung: 30.10.2013
(73) Patentinhaber: Epcos AG, 81669 München (DE)
(72) Erfinder: SCHMIDT, Johann, A-8010 Graz (AT)
(74) Vertreter: Epping - Hermann - Fischer
(86) Internationale Anmeldenummer: PCT/EP2011/073421
(87) Internationale Veröffentlichungsnummer: WO 2012/084957

(56) Entgegenhaltungen:
- DE-A1- 19 802 302
- JP-A- 1 093 184
- JP-A- 7 223 315
- JP-A- 63 120 480

## Beschreibung

Aktoren, beispielsweise Vielschichtaktoren, werden auf verschiedenen Gebieten eingesetzt, ein Beispiel sind Einspritzsysteme für Motoren. Aktoren umfassen Piezoelemente, die sich bei Anlegen einer Spannung ausdehnen. Für Einspritzsysteme sind Aktoren mit immer schnelleren Schaltzeiten bei immer höheren Hüben gewünscht. Beide Forderungen widersprechen sich: Für höhere Hübe sind wegen der maximalen Dehnbarkeit der Keramik in den Aktoren auch längere Aktoren erforderlich. Die Geschwindigkeit, mit der sich der Aktor ausdehnt, hängt von der Schallgeschwindigkeit im Aktor ab. Durch die begrenzte Schallgeschwindigkeit im Aktor werden mit zunehmender Länge des Aktors auch dessen Schaltzeiten länger. Die Dehnung breitet sich innerhalb des Aktors in Form einer elastischen Welle aus. Dabei ist jede einzelne Domäne, also jedes sich ausdehnende Piezoelement, Quelle einer Teilwelle. Diese überlagern sich schlussendlich zu einer Gesamtverformung. Durch die unterschiedlichen Laufzeiten der Teilwellen vom Ort ihrer Entstehung bis zum Aktorkopf ergibt sich auch bei ideal steiler Ansteuerspannung des Aktors eine minimale Flankenzeit der Aktordehnung, das heißt der Zeit, bis der Aktor sich ausgedehnt hat, welche aus physikalischen Gründen nicht unterschritten werden kann.

Zwei Methoden, um höhere Hübe trotz oben genannter Beschränkungen zu erreichen, verwenden relativ kurze Aktoren und haben damit einhergehend kurze Schaltzeiten. Die Hübe oder geforderten Stellwege können durch mechanische Übersetzung mittels eines Kipphebels oder durch mechanische Übersetzung mittels eines hydraulischen Verstärkers erreicht werden.

Die JP 223315 A zeigt einen Aktor mit einer segmentierten Außenelektrode, deren Segmente separat ansteuerbar sind. Diese Ansteuerung ermöglicht, den Aktor zwischen mehr als zwei Ausdehnungsstufen anzusteuern.

Die JP 1093184 A zeigt einen Aktor mit segmentierten Außenelektroden, die eine Grob- und Feinjustierung der Längenveränderung des Aktors erlauben.

Die JP 63120480 A zeigt einen Aktor mit segmentierten Außenelektroden. Diese Anordnung erlaubt, den Aktor zwischen mehr als zwei Ausdehnungsstufen anzusteuern.

Die DE 19802302 A zeigt einen Aktor mit rechteckigem Querschnitt, der Außenelektroden an den vier Außenseiten aufweist. Diese Anordnung reduziert die Rissbildung und verbessert die Wärmeableitung.

Es stellt sich die Aufgabe, einen hinsichtlich der oben genannten Aspekte verbesserten Aktor bereitzustellen.

Die Aufgabe wird durch einen Aktor mit den Merkmalen des Patentanspruchs 1 gelöst.

Es ist ein Aktorsystem mit einer Steueranordnung und einem Aktor vorgesehen, wobei der Aktor in eine vorgegebene Richtung ausdehnbar ist.

Der Aktor ist mit stapelförmig angeordneten Piezoelementen, ersten und zweiten Innenelektroden, die zwischen den Piezoelementen abwechselnd angeordnet sind, einer ersten Außenelektrode, die elektrisch leitend mit den ersten Innenelektroden verbunden ist, und einer zweiten Außenelektrode, die elektrisch leitend mit den zweiten Innenelektroden verbunden ist, vorgesehen. Der Aktor umfasst eine Vielzahl von Aktorabschnitten mit einem ersten Aktorabschnitt, der in der vorgegebenen Richtung relativ zu einem zweiten Aktorabschnitt angeordnet ist. Die zweite Außenelektrode umfasst separate Elektrodensegmente, die jeweils mit den zweiten Innenelektroden in einem der Aktorabschnitte oder in einer Gruppe der Aktorabschnitte elektrisch leitend verbunden sind.

Mittels der Steueranordnung ist ein erstes Ansteuersignal am ersten Aktorabschnitt oder einer ersten Gruppe von Aktorabschnitten und ein zweites Ansteuersignal zeitversetzt an dem zweiten Aktorabschnitt oder einer zweiten Gruppe von Aktorabschnitten anlegbar. Die Steueranordnung ist geeignet, das erste Ansteuersignal an dem ersten Aktorabschnitt oder der ersten Gruppe von Aktorabschnitten zeitverzögert zum zweiten Ansteuersignal an dem zweiten Aktorabschnitt oder der zweiten Gruppe von Aktorabschnitten anzulegen, sodass sich die beim Ausdehnen des Aktors in den jeweiligen Aktorabschnitten oder Gruppen von Aktorabschnitten durch die Ansteuersignale erzeugten elastischen Teilwellen überlagern.

Jeder Aktorabschnitt ist nur mit einem Teil der zweiten Innenelektroden elektrisch leitend verbunden. Die separaten, sich nicht berührenden oder nicht direkt elektrisch leitend miteinander verbundenen Elektrodensegmente erlauben die Aktorabschnitte zeitlich versetzt anzusteuern, sodass der Dehnungsvorgang nicht für alle Piezoelemente zeitgleich in Gang gesetzt wird, sondern zeitlich versetzt.

Der Aktor umfasst mehrere Abschnitte, jeweils mit Piezoelementen und Innenelektroden, welche zeitversetzt angesteuert werden. Die Ansteuerung erfolgt nicht gleichzeitig für alle Bereiche des gesamten Aktors, sondern erfolgt zeitversetzt für deren einzelne Abschnitte. In vorteilhafter Weise wird der Zeitversatz so gewählt, dass er exakt der Schallgeschwindigkeit im Aktor entspricht. Dadurch überlagern sich beim Ausdehnen des Aktors die elastischen Teilwellen derart, dass sich eine wesentlich kürzere Flankenzeit ergibt für die Ausdehnung des Aktors als dies bei gleichzeitiger Ansteuerung der Außenelektrode der Fall wäre. Die untere Grenze der Flankenzeit wird nicht mehr durch die Länge des gesamten Aktors begrenzt, sondern durch die Länge der einzelnen Bereiche.

Weitere vorteilhafte Ausgestaltungen der Erfindung sind in den abhängigen Patentansprüchen angegeben.

In einem Ausführungsbeispiel umfasst auch die erste Außenelektrode separate Elektrodensegmente, die jeweils nur mit einem Teil der ersten Innenelektroden, nämlich mit den ersten Innenelektroden in einem der Aktorabschnitte oder in einer Gruppe der Aktorabschnitte, elektrisch leitend verbunden sind. Das Vorsehen zweier segmentierter Außenelektroden erlaubt größere Freiheitsgrade beim Design des Aktors. Die Aufteilung der Segmente bei der ersten und zweiten Außenelektrode kann übereinstimmen. Alternativ ist die Segmentierung asymmetrisch.

Die Elektrodensegmente sind in einem Ausführungsbeispiel jeweils mit entweder den ersten oder den zweiten Innenelektroden in benachbarten Aktorabschnitten elektrisch leitend verbunden. Dies ermöglicht bei segmentierter erster und segmentierter zweiter Außenelektrode, dass ein erstes Elektrodensegment der ersten Außenelektrode mit den ersten Innenelektroden in einem ersten Aktorabschnitt und einem zweiten, zum ersten benachbarten Aktorabschnitt elektrisch leitend verbunden ist und dass ein zweites Elektrodensegment der zweiten Außenelektrode mit den zweiten Innenelektroden im zweiten Aktorabschnitt und in einem dritten, zum zweiten benachbarten Aktorabschnitt elektrisch leitend verbunden ist. Mit anderen Worten: die ersten und zweiten Außenelektroden sind derart versetzt zueinander angeordnet, sodass sie sowohl Innenelektroden im selben als auch in verschiedenen Aktorabschnitten elektrisch leitend kontaktieren.

In einem Ausführungsbeispiel umfassen zumindest die Elektrodensegmente der zweiten Außenelektrode jeweils ein Terminal, an dem ein Ansteuersignal anlegbar ist. Die zeitlich versetzten Ansteuersignale ermöglichen die zeitversetzte Ansteuerung der Aktorabschnitte. Bei segmentierter erster Außenelektrode haben deren Segmente auch Terminals.

Ein Aktorsystem umfasst einen Aktor und eine Steueranordnung, mittels derer ein erstes Ansteuersignal an einen der Aktorabschnitte und eine zweites Ansteuersignal zeitversetzt an einen weiteren Aktorabschnitt anlegbar ist.

Der Aktor kann sich in eine Richtung ausdehnen, beispielsweise auf Grund seiner Fixierung am Aktorfuß. Ein erster Aktorabschnitt ist in dieser Richtung relativ zu einem zweiten Aktorabschnitt angeordnet, wobei die Steueranordnung geeignet ist, das erste Ansteuersignal am ersten Aktorabschnitt zeitverzögert zum zweiten Ansteuersignal am zweiten Aktorabschnitt anzulegen.

Wenn lediglich eine segmentierte Außenelektrode vorgesehen ist, legt die Steueranordnung die Steuersignale an deren Elektrodensegmente an und die andere Außenelektrode kann mit einem Bezugspotenzial verbunden sein. Bei zwei segmentierten Außenelektroden ist die Steueranordnung geeignet, die Elektrodensegmente, die mit den ersten Innenelektroden verbunden sind, und die Elektrodensegmente, die mit zweiten Innenelektroden verbunden sind, mit Spannungen unterschiedlicher Vorzeichen bezogen auf ein Bezugspotenzial zu beaufschlagen. Das Anlegen verschiedener Ansteuersignale an beiden Außenelektroden ermöglicht eine bessere, flexiblere Ansteuerung des Aktors.

Der Zeitversatz wird in Abhängigkeit der Schallgeschwindigkeit im Aktor gewählt, um Laufzeitunterschiede der Teilwellen auszugleichen.

Eine Ansteuerung eines Aktors mit stapelförmig angeordneten Piezoelementen, ersten und zweiten Innenelektroden, die zwischen den Piezoelementen abwechselnd angeordnet sind, wobei der Aktor eine Vielzahl von Aktorabschnitten umfasst, ist in Anspruch 8 definiert. Zwischen den ersten und den zweiten Innenelektroden wird in einem ersten Aktorabschnitt oder einer ersten Gruppe von Aktorabschnitten eine Ansteuerspannung zeitversetzt zu einer Ansteuerspannung zwischen den ersten und den zweiten Innenelektroden in einem zweiten Aktorabschnitt oder in einer zweiten Gruppe von Aktorabschnitten derart angelegt, dass das erste Ansteuersignal an dem ersten Aktorabschnitt oder der ersten Gruppe von Aktorabschnitten zeitverzögert zum zweiten Ansteuersignal an dem zweiten Aktorabschnitt oder der zweiten Gruppe von Aktorabschnitten liegt, sodass sich die in den jeweiligen Aktorabschnitten oder Gruppen von Aktorabschnitten durch die Ansteuersignale erzeugten elastischen Teilwellen überlagern.

Der Aktor dehnt sich in eine Richtung aus, wobei der erste Aktorabschnitt in der Richtung relativ zu dem zweiten Aktorabschnitt angeordnet ist, und wobei die erste Ansteuerspannung zur zweiten Ansteuerspannung zeitverzögert ist. Nachfolgend wird die Erfindung unter Bezugnahme auf die Zeichnung anhand von Ausführungsbeispielen erklärt.

Es zeigen:
- Figur 1: ein Ausführungsbeispiel eines Aktors ohne segmentierte Außenelektroden,

- Figur 2: den zeitlichen Verlauf der Ansteuerspannung für diesen,
- Figur 3: ein Ausführungsbeispiel eines Aktors mit einer segmentierten Außenelektrode,
- Figur 4: eine perspektivische Ansicht desselben,
- Figur 5: eine schematische Schnittdarstellung desselben,
- Figur 6: den zeitlichen Verlauf der Ansteuerspannungen, die an den Elektrodensegmenten anliegen,
- Figur 7: ein weiteres Ausführungsbeispiel eines Aktors mit zwei segmentierten Außenelektroden,
- Figur 8: den zeitlichen Verlauf der Ansteuerspannungen, die an den Elektrodensegmenten anliegen,

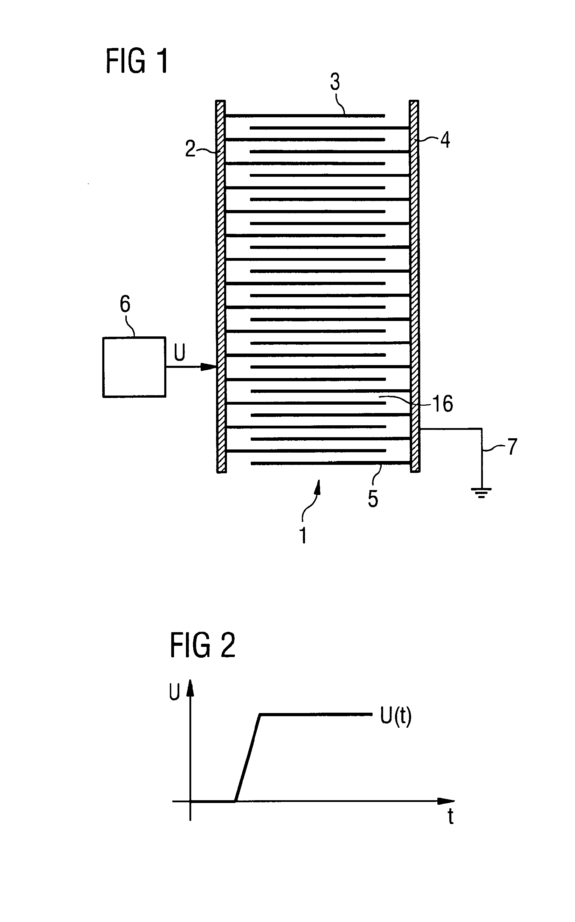

Figur 1 zeigt eine schematische Schnittdarstellung eines konventionellen Vielschichtaktors 1 mit stapelförmig angeordneten Piezoelementen 16. Erste Innenelektroden 5 und zweite Innenelektroden 3 sind zwischen den Piezoelementen 16 abwechselnd angeordnet. Die ersten Innenelektroden 5 sind elektrisch leitend mit einer ersten Außenelektrode 4 verbunden. Die zweiten Innenelektroden 3 sind elektrisch leitend mit einer zweiten Außenelektrode 2 verbunden. Die ersten und zweiten Innenelektroden 5 und 3 sind jeweils zu einer Außenseite des Aktors 1 geführt und werden dort mit der ersten Außenelektrode 4 beziehungsweise zweiten Außenelektrode 2 elektrisch leitend verbunden. Dies kann beispielsweise durch Aufdrucken einer Metallpaste oder durch Anlöten von metallischen Platten erfolgen, welche die Außenelektroden 4, 2 bilden.

Die erste Außenelektrode 4 ist mit einem Bezugspotenzial 7 verbunden. Eine Steueranordnung 6 legt an die zweite Außenelektrode 2 ein Ansteuersignal, beispielsweise ein zeitveränderliches Ansteuerpotenzial an, sodass zwischen den ersten und zweiten Innenelektroden eine Ansteuerspannung U liegt, in Abhängigkeit derer der Aktor 1 gedehnt oder gestaucht wird.

Figur 2 zeigt beispielhaft den Verlauf eines Ansteuersignals, oder Spannung, U in Abhängigkeit von der Zeit t. Der Anstieg des Signals U hat eine endliche Steigung.

Durch Anlegen der Ansteuerspannung U erfährt der Aktor 1 einen Hub. Die Ausdehnung des Aktors 1 erfolgt in endlicher Zeit. Die Dehnung breitet sich innerhalb des Aktors 1 in Form einer elastischen Welle aus. Dabei ist jede einzelne Domäne, oder Piezoelement 16, Quelle einer Teilwelle. Diese überlagern sich, woraus die Gesamtverformung resultiert. Durch die unterschiedlichen Laufzeiten der Teilwellen vom Ort ihrer Entstehung bis zum Aktorkopf ergibt sich auch bei unendlich steiler Ansteuerung eine Zeit, die der Dehnungsprozess erfordert, welche aus physikalischen Gründen nicht unterschritten werden kann. Je länger der Aktor 1 und je größer der Hub desto größer ist auch diese Zeit.

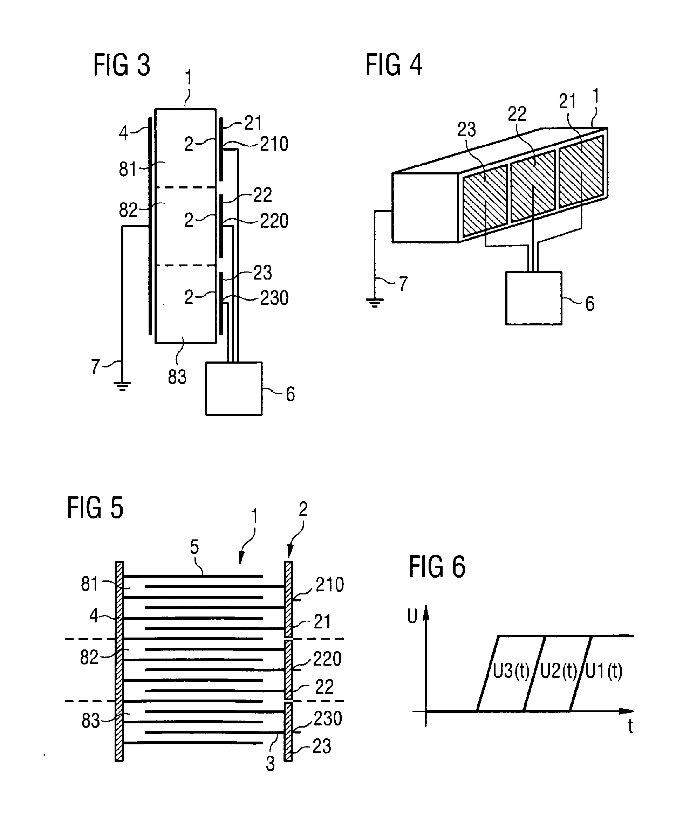

Figur 3 zeigt ein Ausführungsbeispiel eines Vielschichtaktors 1 mit einer ersten Außenelektrode 4 und einer segmentierten zweiten Außenelektrode 2, welche separate Elektrodensegmente 21, 22, 23 aufweist. Die separaten Elektrodensegmente 21, 22, 23 sind räumlich voneinander getrennt. Sie sind weder direkt elektrisch leitend miteinander verbunden noch berühren sie sich. Die erste Außenelektrode 4 ist mit einem Bezugspotenzial 7 verbunden. Die Elektrodensegmente 21, 22, 23 haben jeweils ein Terminal 210, 220, 230, über das sie mit einer Steueranordnung 6 verbunden sind. Über die Terminals 210, 220, 230 sind Ansteuersignale anlegbar.

Figur 4 zeigt das Aktorsystem mit dem Aktor 1 und der Steueranordnung 6 in einer dreidimensionalen Darstellung.

Figur 5 zeigt eine schematische Schnittanordnung des Aktors 1. Der Aktor 1 umfasst erste und zweite Innenelektroden 5, 3, welche mit der ersten Außenelektroden 4 beziehungsweise den zweiter Außenelektroden 2 elektrisch leitend verbunden sind. Der Aktor 1 umfasst eine Mehrzahl von Aktorabschnitten 81, 82, 83. Jeder sich axial erstreckte Aktorabschnitt 81, 82, 83 korrespondiert mit der axialen Ausdehnung der Elektrodensegmente 21, 22, 23. Das erste Elektrodensegment 21 ist elektrisch leitend mit den zweiten Innenelektroden 3 im ersten Aktorabschnitt 81 verbunden. Das zweite Elektrodensegment 22 ist elektrisch leitend mit den zweiten Innenelektroden 3 im zweiten Aktorabschnitt 82 verbunden. Das dritte Elektrodensegment 23 ist elektrisch leitend mit den zweiten Innenelektroden 3 im dritten Aktorabschnitt 83 verbunden. Dagegen sind die ersten Innenelektroden 5 in den drei Aktorabschnitten 81, 82, 83 mit derselben ersten, durchgehenden Außenelektrode 4 elektrisch leitend verbunden.

Figur 6 zeigt schematisch den zeitlichen Verlauf der Ansteuersignale oder der Spannungen U1, U2, U3, die an den Elektrodensegmenten 21, 22, 23 des Aktors 1 anliegen. Am Terminal 210 des ersten Elektrodensegments 21 liegt eine erste Ansteuerspannung U1 an. Am Terminal 220 des zweiten Elektrodensegments 22 liegt eine zweite Ansteuerspannung U2 an. Am Terminal 230 des dritten Elektrodensegments 23 liegt eine dritte Ansteuerspannung U3 an. Die Ansteuerspannungen U1, U2, U3 sind zeitverzögert, sodass die Aktorabschnitte 81, 82, 83 je später angesteuert werden, je näher sie dem Aktorkopf sind. Der Aktor 1 ist am Aktorfuß oder dritten Aktorabschnitt 83 fixiert. In anderen Worten, ein Aktorabschnitt 81, 82, 83, der in Richtung der Aktordehnung relativ zu einem anderen angeordnet ist, wird verzögert angesteuert: Zuerst wird der dritte Aktorabschnitt 83, dann der zweite Aktorabschnitt 82, dann der erste Aktorabschnitt 81 angesteuert. Dabei wird der Zeitversatz so gewählt, dass er der Schallgeschwindigkeit im Aktor 1 entspricht. Dabei überlagern sich die einzelnen Teilwellen der Aktorabschnitte 81, 82, 83 derart, dass sich eine wesentlich kürzere Ausdehnungszeit ergibt. Deren untere Grenze wird nicht mehr durch die Aktorlänge begrenzt, sondern durch die Länge der einzelnen Aktorabschnitte 81, 82, 83.

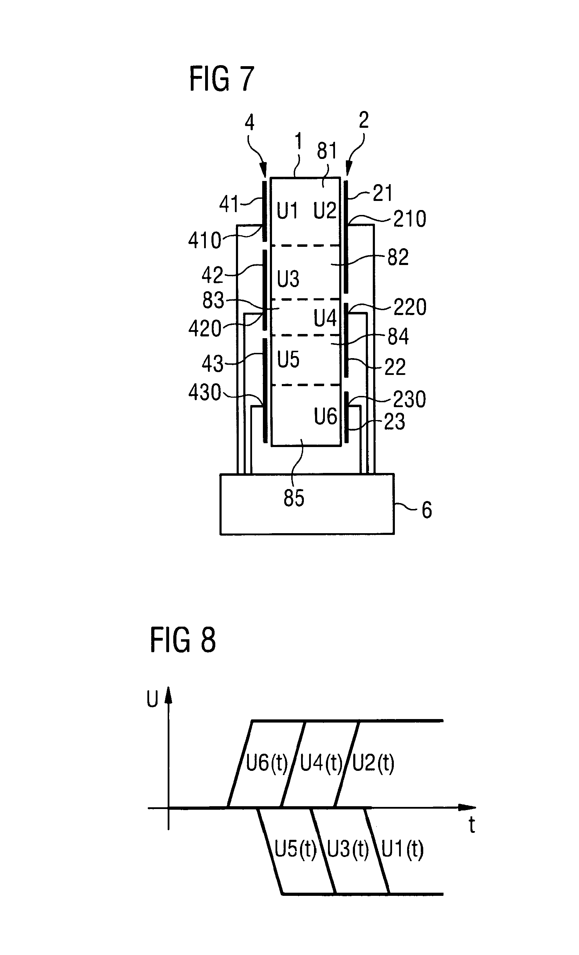

Figur 7 zeigt ein weiteres Ausführungsbeispiel eines Aktors 1 mit einer segmentierten ersten Außenelektrode 4 und einer segmentierten zweiten Außenelektrode 2. Die erste Außenelektrode 4 hat ein erstes, ein zweites und ein drittes Elektrodensegment 41, 42, 43, in diesem Fall unterschiedlicher Länge. Die zweite Außenelektrode 2 hat ein erstes, ein zweites und ein drittes Elektrodensegment 21, 22, 23, in diesem Fall unterschiedlicher Länge. Die Aktorabschnitte 81, 82, 83, 84, 85 erstrecken sich axial zwischen Einschnitten zwischen den Elektrodensegmenten 21, 22, 23, 41, 42, 43. Der Aktor 1 ist am Aktorfuß oder fünften Aktorabschnitt 85 fixiert. Von den Innenelektroden, mit denen jedes Elektrodensegment 21, 22, 23, 41, 42, 43 elektrisch leitend verbunden ist, sind zwei randseitig positioniert, nämlich die obere und untere Innenelektrode, die mit dem Elektrodensegment 21, 22, 23, 41, 42, 43 elektrisch leitend verbunden sind. Die Aktorabschnitte 81, 82, 83, 84, 85 erstrecken sich zwischen zwei benachbarten randseitig positionierten Innenelektroden, wobei diese mit demselben oder mit verschiedenen Elektrodensegmenten 21, 22, 23, 41, 42, 43 elektrisch leitend verbunden sein können. Der erste Aktorabschnitt 81 erstreckt sich axial entlang des ersten Elektrodensegments 41 der ersten Außenelektrode 1. Der zweite Aktorabschnitt 82 erstreckt sich axial von der randseitig positionierten Innenelektrode des zweiten Elektrodensegments 42 der ersten Außenelektrode 1 bis zu der des ersten Elektrodensegments 21 der zweiten Außenelektrode 2. Da die Segmente 41, 42, 43 der ersten Außenelektrode so angeordnet sind, dass sie versetzt gegenüber den Elektrodensegmenten 21, 22, 23 der zweiten Außenelektrode 2 angeordnet sind, sind die Elektrodensegmente 21, 22, 42, 43 mit den Innenelektroden benachbarter Aktorabschnitte 81, 82, 83, 84, 85 elektrisch leitend verbunden. So ist beispielsweise das erste Elektrodensegment 21 der zweiten Außenelektrode 2 elektrisch leitend mit den zweiten Innenelektroden des ersten und zweiten Aktorabschnitts 81, 82 elektrisch leitend verbunden. Das zweite Elektrodensegment 42 der ersten Außenelektrode 4 ist elektrisch leitend mit den ersten Innenelektroden 5 im zweiten und dritten Aktorabschnitt 82, 83 elektrisch leitend verbunden.

Figur 8 zeigt den zeitlichen Verlauf der Steuersignale oder Bezugspotenziale bezogen auf ein Referenzpotenzial, U1, U2, U3, U4, U5, U6, die von der Steueranordnung 6 in Figur 7 bereitgestellt werden. Die erste Ansteuerspannung U1 liegt am Terminal 410 des ersten Elektrodensegments 41 der ersten Außenelektrode 4 an. Die dritte Ansteuerspannung U3 liegt am Terminal 420 des zweiten Elektrodensegments 42 der ersten Außenelektrode 4 an. Die fünfte Ansteuerspannung U5 liegt am Terminal 430 des dritten Elektrodensegments 43 der ersten Außenelektrode 4 an. Die zweite Ansteuerspannung U2 liegt am Terminal 210 des ersten Elektrodensegments 21 der zweiten Außenelektrode 2 an. Die vierte Ansteuerspannung U4 liegt am Terminal 220 des zweiten Elektrodensegments 22 der zweiten Außenelektrode 2 an. Die sechste Ansteuerspannung U6 liegt am Terminal 230 des dritten Elektrodensegments 23 der zweiten Außenelektrode 2 an. Die Vorzeichen der ersten, dritten, fünften Ansteuerspannung U1, U3, U5 sind gegensätzlich zum Vorzeichen der zweiten, vierten und sechsten Ansteuerspannung U2, U4, U6.

Durch Ansteigen der sechsten Ansteuerspannung U6 wird zunächst der fünfte Aktorabschnitt 85 angesteuert. Mit Ansteigen der fünften Ansteuerspannung U5, welche am dritten Elektrodensegment 43 der ersten Außenelektrode 4 anliegt, wird sowohl die Spannung zwischen den ersten und zweiten Innenelektroden 5, 3 des fünften Aktorabschnitts 85 erhöht, da sich die Potenzialdifferenz erhöht, als auch begonnen, den vierten Aktorabschnitt 84 anzusteuern. Mit Ansteigen der vierten Ansteuerspannung U4, welche am zweiten Elektrodensegment 22 der zweiten Außenelektrode 2 anliegt, wird sowohl die Spannung zwischen den ersten und zweiten Innenelektroden 5, 3 des vierten Aktorabschnitts 84 erhöht, da sich die Potenzialdifferenz erhöht, als auch begonnen, den dritten Aktorabschnitt 83 anzusteuern. Diese Ansteuerung wird sukzessive für die anderen Aktorabschnitte fortgesetzt.

Die nicht randseitigen Aktorabschnitte 82, 83, 84 werden auf Grund der überlappenden Anordnung der Segmente 21, 22, 23, 41, 42, 43 der Außenelektroden 4, 2 jeweils in zwei Schritten angesteuert.

Es sei bemerkt, dass die zeitliche Abfolge der Spannungsanstiege beziehungsweise -abfälle an den Terminals 210, 220, 230, 410, 420, 430 für Dehnung und Stauchung die gleiche ist, sich die Spannungsanstiege beziehungsweise -abfälle an einzelnen Terminals 210, 220, 230, 410, 420, 430 bei Dehnung und Stauchung aber hinsichtlich ihres Vorzeichens unterscheiden.

Es sei bemerkt, dass die Merkmale der Ausführungsbeispiele kombinierbar sind.

### Bezugszeichen

- 1: Aktor
- 4, 2: Außenelektrode
- 5, 3: Innenelektrode
- 6: Steueranordnung
- 7: Bezugspotenzial
- 16: Piezoelement
- 21, 21, 23, 41, 42, 43: Elektrodensegment
- 81, 82, 83, 84, 85: Aktorabschnitt
- 210, 210, 230, 410, 420, 430: Terminal

## Patentansprüche

1. Aktorsystem mit einer Steueranordnung (6) und einem Aktor (1), wobei der Aktor (1), der in eine vorgegebene Richtung ausdehnbar ist, umfasst
- stapelförmig angeordnete Piezoelemente (16),
- erste und zweite Innenelektroden (5, 3), die zwischen den Piezoelementen (16) abwechselnd angeordnet sind,
- eine erste Außenelektrode (4), die elektrisch leitend mit den ersten Innenelektroden (5) verbunden ist,
- eine zweite Außenelektrode (2), die elektrisch leitend mit den zweiten Innenelektroden (3) verbunden ist,
- eine Mehrzahl von Aktorabschnitten (81, 82, 83, 84, 85) mit einem ersten Aktorabschnitt (81, 82, 83, 84, 85), der in der vorgegebenen Richtung relativ zu einem zweiten Aktorabschnitt (81, 82, 83, 84, 85) angeordnet ist, wobei die zweite Außenelektrode (2) separate Elektrodensegmente (21, 22, 23) umfasst, die jeweils mit den zweiten Innenelektroden (3) in einem der Aktorabschnitte (81, 82, 83, 84, 85) oder in einer Gruppe der Aktorabschnitte (81, 82, 83, 84, 85) elektrisch leitend verbunden sind,
**dadurch gekennzeichnet, dass**
mittels der Steueranordnung (6) ein erstes Ansteuersignal (U1, U2, U3, U4, U5, U6) an den ersten Aktorabschnitt (81, 82, 83, 84, 85) oder eine erste Gruppe von Aktorabschnitten (81 , 82, 83, 84, 85) und ein zweites Ansteuersignal (U1, U2, U3, U4, U5, U6) zeitversetzt an den zweiten Aktorabschnitt (81, 82, 83, 84, 85) oder eine zweite Gruppe von Aktorabschnitten (81, 82, 83, 84, 85) derart anlegbar ist, dass das erste Ansteuersignal (U1, U2, U3, U4, U5, U6) an dem ersten Aktorabschnitt oder der ersten Gruppe von Aktorabschnitten zeitverzögert zum zweiten Ansteuersignal (U1, U2, U3, U4, U5, U6) an dem zweiten Aktorabschnitt oder der zweiten Gruppe von Aktorabschnitten liegt, sodass sich die beim Ausdehnen des Aktors in den jeweiligen Aktorabschnitten oder Gruppen von Aktorabschnitten durch die Ansteuersignale erzeugten elastischen Teilwellen überlagern.

2. Aktorsystem nach Anspruch 1,
**dadurch gekennzeichnet, dass**
die erste Außenelektrode (4) separate Elektrodensegmente (41, 42, 43) umfasst, die jeweils mit den ersten Innenelektroden (5) in einem der Aktorabschnitte (81, 82, 83, 84, 85) oder in einer Gruppe der Aktorabschnitte (81, 82, 83, 84, 85) elektrisch leitend verbunden sind.

3. Aktorsystem nach Anspruch 1 oder 2,
**dadurch gekennzeichnet, dass**
die Elektrodensegmente (21, 22, 23, 41, 42, 43) jeweils mit entweder den ersten oder den zweiten Innenelektroden (5, 3) in benachbarten Aktorabschnitten (81, 82, 83, 84, 85) elektrisch leitend verbunden sind.

4. Aktorsystem nach einem der vorhergehenden Ansprüche,
**dadurch gekennzeichnet, dass**
ein erstes Elektrodensegment (42, 43) mit den ersten Innenelektroden (5) in einem ersten und einem zweiten, dazu benachbarten Aktorabschnitt (82, 83; 84, 85) elektrisch leitend verbunden ist und dass ein zweites Elektrodensegment (21, 22) mit den zweiten Innenelektroden (3) im zweiten und in einem dritten, dazu benachbarten Aktorabschnitt (82, 81; 84, 83) elektrisch leitend verbunden ist.

5. Aktorsystem nach einem der vorhergehenden Ansprüche,
**dadurch gekennzeichnet, dass**
zumindest die Elektrodensegmente (21, 22, 23) der zweiten Außenelektrode (2) jeweils ein Terminal (210, 220, 230) umfassen, an denen ein Ansteuersignal (U1, U2, U3, U4, U6) anlegbar ist.

6. Aktorsystem nach einem der vorhergehenden Ansprüche
**dadurch gekennzeichnet, dass**
die Steueranordnung (6) geeignet ist, die Elektrodensegmente (41, 42, 43), die mit den ersten Innenelektroden (5) verbunden sind, und die Elektrodensegmente (21, 22, 23), die mit zweiten Innenelektroden (3) verbunden sind, mit Spannungen (U1, U2, U3, U4, U5, U6) unterschiedlicher Vorzeichen bezogen auf ein Bezugspotenzial (7) zu beaufschlagen.

7. Aktorsystem nach einem der vorhergehenden Ansprüche,
**dadurch gekennzeichnet, dass**
der Zeitversatz von der Schallgeschwindigkeit im Aktor (1) abhängt.

8. Verfahren zur Ansteuerung eines Aktors (1), der in eine vorgegebene Richtung ausdehnbar ist, mit stapelförmig angeordneten Piezoelementen (16), ersten und zweiten Innenelektroden (5, 3), die zwischen den Piezoelementen (16) abwechselnd angeordnet sind, wobei der Aktor (1) eine Vielzahl von Aktorabschnitten (81, 82, 83, 84, 85) mit einem ersten Aktorabschnitt (81, 82, 83, 84, 85), der in der vorgegebenen Richtung relativ zu einem zweiten Aktorabschnitt (81, 82, 83, 84, 85) angeordnet ist, umfasst und zwischen den ersten und den zweiten Innenelektroden (5, 3) in dem ersten Aktorabschnitt (81, 82, 83, 84, 85) oder in einer ersten Gruppe von Aktorabschnitten (81, 82, 83, 84, 85) eine erste Ansteuerspannung zeitversetzt zu einer zweiten Ansteuerspannung zwischen den ersten und den zweiten Innenelektroden (5, 3) in dem zweiten Aktorabschnitt (81, 82, 83, 84 85) oder in einer zweiten Gruppe von Aktorabschnitten (81, 82, 82, 84, 85) derart angelegt wird, dass das erste Ansteuersignal (U1, U2, U3, U4, U5, U6) an dem ersten Aktorabschnitt oder der ersten Gruppe von Aktorabschnitten zeitverzögert zum zweiten Ansteuersignal (U1, U2, U3, U4, U5, U6) an dem zweiten Aktorabschnitt oder der zweiten Gruppe von Aktorabschnitten liegt, sodass sich die beim Ausdehnen des Aktors in den jeweiligen Aktorabschnitten oder Gruppen von Aktorabschnitten durch die Ansteuersignale erzeugten elastischen Teilwellen überlagern.

9. Verfahren zur Ansteuerung nach Anspruch 8,
**dadurch gekennzeichnet, dass**
der Aktor (1) in eine Richtung ausdehnbar ist, wobei der erste Aktorabschnitt (81, 82, 83, 84, 85) in der Richtung relativ zu dem zweiten Aktorabschnitt (81, 82, 83, 84, 85) angeordnet ist, und wobei die erste Ansteuerspannung zur zweiten Ansteuerspannung zeitverzögert ist.

10. Verfahren zur Ansteuerung nach Anspruch 8 oder 9,
**dadurch gekennzeichnet, dass**
der Zeitversatz in Abhängigkeit der Schallgeschwindigkeit im Aktor (1) gewählt wird.

## Claims

1. Actuator system comprising a control arrangement (6) and an actuator (1), wherein the actuator (1), which is expandable in a predefined direction, comprises
- piezoelements (16) arranged in a stacked fashion,
- first and second internal electrodes (5, 3) arranged alternately between the piezoelements (16),
- a first external electrode (4), which is electrically conductively connected to the first internal electrodes (5),
- a second external electrode (2), which is electrically conductively connected to the second internal electrodes (3),
- a plurality of actuator sections (81, 82, 83, 84, 85) comprising a first actuator section (81, 82, 83, 84, 85), which is arranged in the predefined direction relative to a second actuator section (81, 82, 83, 84, 85), wherein the second external electrode (2) comprises separate electrode segments (21, 22, 23), which are electrically conductively connected in each case to the second internal electrodes (3) in one of the actuator sections (81, 82, 83, 84, 85) or in a group of the actuator sections (81, 82, 83, 84, 85),
**characterized in that**, by means of the control arrangement (6), a first control signal (U1, U2, U3, U4, U5, U6) can be applied to the first actuator section (81, 82, 83, 84, 85) or a first group of actuator sections (81, 82, 83, 84, 85) and a second control signal (U1, U2, U3, U4, U5, U6) can be applied in a time-shifted manner to the second actuator section (81, 82, 83, 84, 85) or a second group of actuator sections (81, 82, 83, 84, 85) in such a way that the first control signal (U1, U2, U3, U4, U5, U6) is at the first actuator section or the first group of actuator sections in a time-delayed manner with respect to the second control signal (U1, U2, U3, U4, U5, U6) at the second actuator section or the second group of actuator sections, so that the elastic partial waves generated by the control signals during the expansion of the actuator in the respective actuator sections or groups of actuator sections are superimposed.

2. Actuator system according to Claim 1,
**characterized in that**
the first external electrode (4) comprises separate electrode segments (41, 42, 43) which are electrically conductively connected in each case to the first internal electrodes (5) in one of the actuator sections (81, 82, 83, 84, 85) or in a group of the actuator sections (81, 82, 83, 84, 85).

3. Actuator system according to Claim 1 or 2,
**characterized in that**
the electrode segments (21, 22, 23, 41, 42, 43) are electrically conductively connected in each case to either the first or the second internal electrodes (5, 3) in adjacent actuator sections (81, 82, 83, 84, 85).

4. Actuator system according to any of the preceding claims,
**characterized in that**
a first electrode segment (42, 43) is electrically conductively connected to the first internal electrodes (5) in a first and a second actuator section (82, 83; 84, 85) adjacent thereto, and **in that** a second electrode segment (21, 22) is electrically conductively connected to the second internal electrodes (3) in the second and in a third actuator section (82, 81; 84, 83) adjacent thereto.

5. Actuator system according to any of the preceding claims,
**characterized in that**
at least the electrode segments (21, 22, 23) of the second external electrode (2) in each case comprise a terminal (210, 220, 230), to which a control signal (U1, U2, U3, U4, U6) can be applied.

6. Actuator system according to any of the preceding claims,
**characterized in that**
the control arrangement (6) is suitable for applying voltages (U1, U2, U3, U4, U5, U6) having different signs relative to a reference-ground potential (7) to the electrode segments (41, 42, 43) connected to the first internal electrodes (5) and the electrode segments (21, 22, 23) connected to second internal electrodes (3).

7. Actuator system according to any of the preceding claims,
**characterized in that**
the time shift is dependent on the velocity of sound in the actuator (1).

8. Method for the control of an actuator (1), which is expandable in a predefined direction, comprising piezoelements (16) arranged in a stacked fashion, first and second internal electrodes (5, 3) arranged alternately between the piezoelements (16), wherein the actuator (1) comprises a multiplicity of actuator sections (81, 82, 83, 84, 85) comprising a first actuator section (81, 82, 83, 84, 85), which is arranged in the predefined direction relative to a second actuator section (81, 82, 83, 84, 85), and a first control voltage is applied between the first and second internal electrodes (5, 3) in the first actuator section (81, 82, 83, 84, 85) or in a first group of actuator sections (81, 82, 83, 84, 85) in a time-shifted manner with respect to a second control voltage applied between the first and second internal electrodes (5, 3) in the second actuator section (81, 82, 83, 84, 85) or in a second group of actuator sections (81, 82, 83, 84, 85) in such a way that the first control signal (U1, U2, U3, U4, U5, U6) is at the first actuator section or the first group of actuator sections in a time-delayed manner with respect to the second control signal (U1, U2, U3, U4, U5, U6) at the second actuator section or the second group of actuator sections, so that the elastic partial waves generated by the control signals during the expansion of the actuator in the respective actuator sections or groups of actuator sections are superimposed.

9. Control method according to Claim 8,
**characterized in that**
the actuator (1) is expandable in one direction, wherein the first actuator section (81, 82, 83, 84, 85) is arranged in the direction relative to the second actuator section (81, 82, 83, 84, 85), and wherein the first control voltage is time-delayed with respect to the second control voltage.

10. Control method according to Claim 8 or 9,
**characterized in that**
the time shift is chosen in a manner dependent on the velocity of sound in the actuator (1).

## Revendications

1. Système actionneur comprenant un arrangement de commande (6) et un actionneur (1), l'actionneur (1), qui peut s'étendre dans une direction prédéfinie, comprenant :
- des éléments piézoélectriques (16) disposés en forme de pile,
- des premières et deuxièmes électrodes internes (5, 3) qui sont disposées en alternance entre les éléments piézoélectriques (16),
- une première électrode externe (4) qui est reliée de manière électriquement conductrice aux premières électrodes internes (5),
- une deuxième électrode externe (2) qui est reliée de manière électriquement conductrice aux deuxièmes électrodes internes (3),
- une pluralité de portions d'actionneur (81, 82, 83, 84, 85) avec une première portion d'actionneur (81, 82, 83, 84, 85) qui est disposée dans la direction prédéfinie par rapport à une deuxième portion d'actionneur (81, 82, 83, 84, 85), la deuxième électrode externe (2) comprenant des segments d'électrode (21, 22, 23) séparés qui sont respectivement reliés de manière électriquement conductrice aux deuxièmes électrodes internes (3) dans l'une des portions d'actionneur (81, 82, 83, 84, 85) ou dans un groupe de portions d'actionneur (81, 82, 83, 84, 85),
**caractérisé en ce que**
un premier signal de commande (U1, U2, U3, U4, U5, U6) peut être appliqué à la première portion d'actionneur (81, 82, 83, 84, 85) ou à un premier groupe de portions d'actionneur (81, 82, 83, 84, 85) et un deuxième signal de commande (U1, U2, U3, U4, U5, U6) peut être appliqué avec un décalage dans le temps à la deuxième portion d'actionneur (81, 82, 83, 84, 85) ou à un deuxième groupe de portions d'actionneur (81, 82, 83, 84, 85) au moyen de l'arrangement de commande (6) de telle sorte que le premier signal de commande (U1, U2, U3, U4, U5, U6) est appliqué à la première portion d'actionneur ou au premier groupe de portions d'actionneur avec un retard dans le temps par rapport au deuxième signal de commande (U1, U2, U3, U4, U5, U6) appliqué à la deuxième portion d'actionneur ou au deuxième groupe de portions d'actionneur, de sorte que les ondes partielles élastiques générées lors de l'extension de l'actionneur dans les portions d'actionneur respectives ou les groupes de portions d'actionneur respectifs par les signaux de commande se superposent.

2. Système actionneur selon la revendication 1, **caractérisé en ce que** la première électrode externe (4) comprend des segments d'électrode (41, 42, 43) séparés qui sont respectivement reliés de manière électriquement conductrice aux premières électrodes internes (5) dans l'une des portions d'actionneur (81, 82, 83, 84, 85) ou dans un groupe de portions d'actionneur (81, 82, 83, 84, 85).

3. Système actionneur selon la revendication 1 ou 2, **caractérisé en ce que** les segments d'électrode (21, 22, 23, 41, 42, 43) sont respectivement reliés de manière électriquement conductrice soit aux premières soit aux deuxièmes électrodes internes (5, 3) dans des portions d'actionneur (81, 82, 83, 84, 85) voisines.

4. Système actionneur selon l'une des revendications précédentes, **caractérisé en ce qu'**un premier segment d'électrode (42, 43) est relié de manière électriquement conductrice aux premières électrodes internes (5) dans une première portion d'actionneur et dans une deuxième voisine de celle-ci (82, 83 ; 84, 85), et **en ce qu'**un deuxième segment d'électrode (21, 22) est relié de manière électriquement conductrice aux deuxièmes électrodes internes (3) dans la deuxième portion d'actionneur et dans une troisième voisine de celle-ci (82, 81 ; 84, 83).

5. Système actionneur selon l'une des revendications précédentes, **caractérisé en ce qu'**au moins les segments d'électrode (21, 22, 23) de la deuxième électrode externe (2) comprennent respectivement une borne (210, 220, 230) à laquelle peut être appliqué un signal de commande (U1, U2, U3, U4, U6).

6. Système actionneur selon l'une des revendications précédentes, **caractérisé en ce que** l'arrangement de commande (6) est adapté pour charger les segments d'électrode (41, 42, 43), qui sont reliés aux premières électrodes internes (5), et les segments d'électrode (21, 22, 23), qui sont reliés aux deuxièmes électrodes internes (3), avec des tensions (U1, U2, U3, U4, U5, U6) ayant des signes différents par rapport à un potentiel de référence (7).

7. Système actionneur selon l'une des revendications précédentes, **caractérisé en ce que** le décalage dans le temps dépend de la vitesse du son dans l'actionneur (1).

8. Procédé de commande d'un actionneur (1), qui peut s'étendre dans une direction prédéfinie, comprenant des éléments piézoélectriques (16) disposés en forme de pile, des premières et deuxièmes électrodes internes (5, 3) qui sont disposées en alternance entre les éléments piézoélectriques (16), l'actionneur (1) comprenant une pluralité de portions d'actionneur (81, 82, 83, 84, 85) avec une première portion d'actionneur (81, 82, 83, 84, 85) qui est disposée dans la direction prédéfinie par rapport à une deuxième portion d'actionneur (81, 82, 83, 84, 85), et une première tension de commande étant appliquée entre les premières et deuxièmes électrodes internes (5, 3) dans la première portion d'actionneur (81, 82, 83, 84, 85) ou dans un premier groupe de portions d'actionneur (81, 82, 83, 84, 85) avec un décalage dans le temps par rapport à une deuxième tension de commande entre les premières et deuxièmes électrodes internes (5, 3) dans la deuxième portion d'actionneur (81, 82, 83, 84, 85) ou dans un deuxième groupe de portions d'actionneur (81, 82, 83, 84, 85) de telle sorte que le premier signal de commande (U1, U2, U3, U4, U5, U6) est appliqué à la première portion d'actionneur ou au premier groupe de portions d'actionneur avec un retard dans le temps par rapport au deuxième signal de commande (U1, U2, U3, U4, U5, U6) appliqué à la deuxième portion d'actionneur ou au deuxième groupe de portions d'actionneur, de sorte que les ondes partielles élastiques générées lors de l'extension de l'actionneur dans les portions d'actionneur respectives ou les groupes de portions d'actionneur respectifs par les signaux de commande se superposent.

9. Procédé de commande selon la revendication 8, **caractérisé en ce que** l'actionneur (1) peut s'étendre dans une direction, la première portion d'actionneur (81, 82, 83, 84, 85) étant disposée dans la direction par rapport à la deuxième portion d'actionneur (81, 82, 83, 84, 85), et la première tension de commande étant retardée dans le temps par rapport à la deuxième tension de commande.

10. Procédé de commande selon la revendication 8 ou 9, **caractérisé en ce que** le décalage dans le temps est choisi en fonction de la vitesse du son dans l'actionneur (1).
